# EUROPEAN PATENT APPLICATION

(11) **EP 4 608 078 A1**
(43) Date of publication of application: **27.08.2025**
(21) Application number: 24158718.7
(22) Date of filing: 20.02.2024
(51) Int. Cl.: H05K 3/22, H05K 3/00, H05K 3/28

(54) **METHOD AND SYSTEM FOR STACK RECYCLING**

(71) Applicant: Nederlandse Organisatie voor toegepast-natuurwetenschappelijk Onderzoek TNO, 2595 DA 's-Gravenhage (NL)
(72) Inventor: HARKEMA, Stephan, 2595 DA 's-Gravenhage (NL); DE KOK, Margaretha Maria, 2595 DA 's-Gravenhage (NL); RENTROP, Cornelis Hermanus Arnoldus, 2595 DA 's-Gravenhage (NL)
(74) Representative: V.O.

(57) **Abstract**

A method and system for recycling a stack (10). The stack (10) comprises a set of constituents (11) disposed on a first side of a carrier substrate (12). A counter-substrate (13) is applied onto the first side of the carrier substrate (12) to encapsulate and/or adhere to the set of constituents (11). Preferably, the counter-substrate (13) is applied as an at least partially liquefied material (13m). The carrier substrate (12) is isolated from the set of constituents (11) by separating the counter-substrate (13) from the carrier substrate (12). Preferably, the stack (10) comprises a sacrificial layer (14) between the carrier substrate (12) and the set of constituents (11) for facilitating the separating. For example, the separation may be initiated by applying a trigger to the sacrificial layer (14). Advantageously, the counter-substrate (13) may hold together the set of constituents (11), e.g. while the sacrificial layer (14) may be disintegrated.

## Description

### TECHNICAL FIELD AND BACKGROUND

The present disclosure relates to a method and system for recycling a stack, in particular a stack comprising electronics.

The growing need for integrated electronic features presents sustainability challenges in the recycling of electronic waste. Printed circuit boards (PCBs) are commonly found in electronic products and can be difficult to recycle due to their complex combination of materials, including plastics, metals, and semiconductor components. The prevalent end-of-life scenario involves shredding and incineration, contributing to a significant environmental burden. Printed electronics (PEs) offer potential solutions to this problem by using thinner devices, printed functionalities, and recyclable materials. This aligns with the goal of reducing the environmental impact. However, to achieve a circular economy for electronics, disassembly methods must be improved. An example of this is WO 2022/220688, which discloses an electronic device with a delamination layer specifically designed for end-of-life disassembly. The disclosed method can be further improved, for example, by preventing contamination of the recovered materials, such as plastics, by fragile metal and/or coating layers present in the stack of the electronic device.

The present invention aims to improve recycling of constituents like plastics and metals from the stack of an electronic device, promoting a sustainable and circular electronic ecosystem.

### SUMMARY

At the end of their life, electronics should be recycled. Certain electronic components are best recycled through shredding, melting, or dissolution. To minimize environmental impact and enable closed-loop recycling, electronic waste should be recovered in its purest form possible. Electronic devices contain various constituents, such as thin metal layers and protective coatings, that may break down during the recovery process. This can create debris and microparticles that are harmful to recycling facility staff, contaminate recovered materials, and reduce recovery yield. The present invention addresses these or other issues by adding a temporary layer to the stack for safe removal and recycling of its constituents as opposed to the immediate disassembly process.

The stack comprises a set of constituents disposed on a first side of a carrier substrate. The method of recycling the stack according to the present invention comprises applying a counter-substrate onto the first side of the carrier substrate to encapsulate and/or adhere to the set of constituents. Subsequent to the applying is the carrier substrate isolated from the set of constituents by separating the counter-substrate from the carrier substrate. The counter-substrate is configured to hold together the set of constituents while being isolated from the carrier substrate. As will be appreciated, the counter-substrate can be relatively thin, e.g. as compared to other layers, and/or made of a material that is easily recoverable and/or recyclable.

By encapsulating the set of constituents, e.g. metal tracks or coatings, into the counter-substrate, its integrity can be preserved when being separated off the carrier substrate, thereby preventing release of hazardous particulates at unwanted stages of the recycling process. Additionally, high value constituents, e.g. rare metals, adhesives, or solders can be recollected for further recycling without the risk of contamination or losing these in filters.

By applying the counter-substrate as an at least partially liquefied material, the set of constituents can be encapsulated and/or adhered from multiple directions, e.g. top and/or side. The liquefied material may be applied sequentially to each side of a carrier substrate comprising a set of constituents disposed on both sides of the carrier substrate. For example, the liquefied material is applied on the first side of the carrier substrate, the carrier substrate is turned upside down, so that the liquefied material can be applied on the second side of the carrier substrate. Alternatively, or in addition, the liquefied material can be applied on the set of constituents comprised on at least one side of the carrier substrate by a spray coating and/or dipping.

The step of separating the counter-substrate from the carrier substrate can be enhanced by introducing a weak link in the stack, e.g. providing the stack with a sacrificial layer configured to deliberately degrade, dissolve, disrupt, or weaken the adhesive strength of the sacrificial layer with the carrier substrate, thereby providing the benefit of retrieving the carrier substrate in its pure form and maximizing the recovery of the set of constituents, e.g. printed metals, solders or other components that undergo further recycling without contaminating the carrier substrate and/or generating hazardous microparticles.

Preferably, to avoid degradation of the stack during use, the sacrificial layer is activated just prior or after the application of the counter-substrate using an external or internal trigger. Preferably, the external trigger comprises application of light to weaken the sacrificial layer, e.g. photonic debonding. Alternatively, or in addition, the internal trigger comprises deliberate, e.g. resistive, heat dissipation by at least some of the set of constituents.

In some embodiments, the counter-substrate and the sacrificial layer are used collaboratively together during the isolation of the carrier substrate from the stack, e.g. the set of constituents. For example, when the counter-substrate is peeled off the carrier substrate, the counter-substrate holds the set of constituents together while the sacrificial layer eases the peeling by weakening the adhesion of the set of constituents with the carrier substrate. The counter-substrate comprising the set of constituents, can be removed, e.g. by dissolution, to release the set of constituents for further processing. Preferably, the counter-substrate is fully miscible in non-toxic solvents with overall low environmental impact, e.g. water, and/or biodegradable. Alternatively, or in addition, the counter-substrate is formed by a reusable adhesive, e.g. a flexible and/or conformable gel-based and/or silicone-based adhesive.

To facilitate the separating of the counter-substrate from the carrier substrate, the adhesion of the counter-substrate to the stack and/or to the set of constituents can be improved by removing any existing layer(s) covering the set of constituents on stack precursor prior to applying the counter-substrate.

Advantageously, the method of recycling a stack and/or a stack precursor is realized by a (semi-automated) recycling system for closed-loop recycling of various electronics, e.g. in-mold structural electronics, flexible lighting foils, flexible sensors, microelectromechanical systems, chips, and/or near field communication modules.

### BRIEF DESCRIPTION OF DRAWINGS

These and other features, aspects, and advantages of the apparatus, systems and methods of the present disclosure will become better understood from the following description, appended claims, and accompanying drawing wherein:
FIGs 1A-D illustrate recycling of a stack;
FIGs 2A-D illustrate recycling of an encapsulated stack;
FIG 3A illustrates recycling of a counter-substrate;
FIG 3B illustrates recycling of a carrier substrate;
FIG 3C illustrates a system for recycling a stack.

### DESCRIPTION OF EMBODIMENTS

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

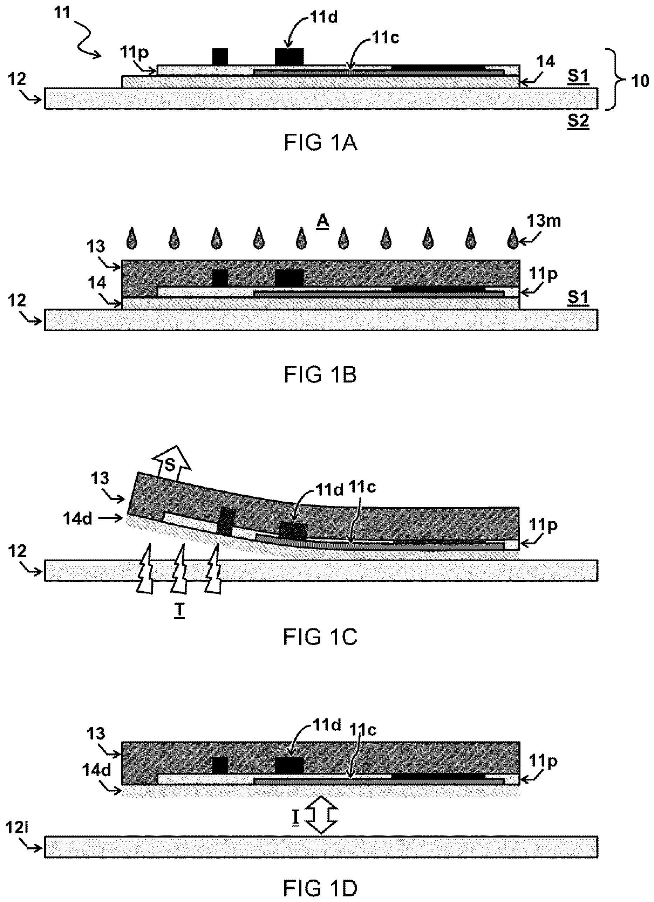

FIG 1A-D illustrates a method of recycling a stack 10 comprising a set of constituents 11 disposed on a first side S1 of a carrier substrate 12. The method comprises applying A a counter-substrate 13 onto the first side S 1 of the carrier substrate 12 to encapsulate and/or adhere to the set of constituents 11. The method further comprises isolating I the carrier substrate 12 from the set of constituents 11 by separating S the counter-substrate 13 from the carrier substrate 12. In some embodiments, the counter-substrate 13 is configured to hold the set of constituents 11 together while being isolated from the carrier substrate 12. In one embodiment, the counter-substrate 13 has a minimal thickness needed to hold the set of constituents 11 together, e.g. at least one micrometer, preferably forty micrometers, up to hundred micrometers or more. In another or further embodiment, the counter-substrate 13 has a maximum thickness of one millimeter, preferably hundred micrometers, or less to avoid unnecessary waste of the counter-substrate material.

In some other or further embodiments, the set of constituents is disposed on both the first side S1 and the second side S2 of the carrier substrate 12, in which case the counter-substrate 13 is applied on both sides S1 and S2 of the carrier substrate 12. Preferably, the counter-substrate 13 is applied onto the set of constituents 11 as an at least partially liquefied material 13m. In one embodiment, the material is solidified to form the counter-substrate 13. Alternatively, or in addition, the counter-substrate 13 is applied as coating by spraying, dipping, and/or other type of material deposition, e.g. using a cleanable and/or reusable gel-based and/or silicone-based adhesive that folds around the set of constituents 11.

In other or further embodiments, the stack 10 comprises a sacrificial layer 14 between the carrier substrate 12 and the set of constituents 11 for facilitating the separating of the set of constituents 11 from the carrier substrate 12. In one embodiment, the set of constituents 11 is disposed directly on the sacrificial layer 14. In another or further embodiment, the sacrificial layer 14 is much thinner as compared to the counter-substrate 13. For example, the sacrificial layer 14 is a factor of two, four, or ten thinner than the counter-substrate 13. In another or further embodiment, the sacrificial layer 14 comprises particles that change volume when exposed to warm and/or humid conditions, e.g. carbon-based particles. In yet another or further embodiment, the sacrificial layer 14 comprises material that changes its volumetric and/or adhesive property when exposed to visible, ultra-violet, or infra-red light.

In yet further embodiments, the method comprises applying a trigger T to the sacrificial layer 14 after applying the counter-substrate 13. In one embodiment, the trigger T is configured to weaken, degrade, disintegrate, and/or release the adhesion of the sacrificial layer 14 to the carrier substrate 12. In some embodiments, the trigger is applied externally. In one embodiment, the trigger comprises intentional heating under humid conditions, e.g. hydrolysis, to achieve weekend adhesion of the sacrificial layer 14. In another or further embodiment, the sacrificial layer 14 is debonded by applying light, e.g. using photonic debonding. Alternatively, or in addition, the integrity of the sacrificial layer is degraded by the dissolution, photooxidation, enzymatic or chemical reaction, and/or radiation. In other or further embodiments, the trigger is applied internally, e.g. by intentionally (over)heating at least some of the set of constituents comprised in the stack 10. Preferably, to avoid deterioration of the stack during its normal use, the trigger is applied immediately prior or after the application of the counter-substrate 13.

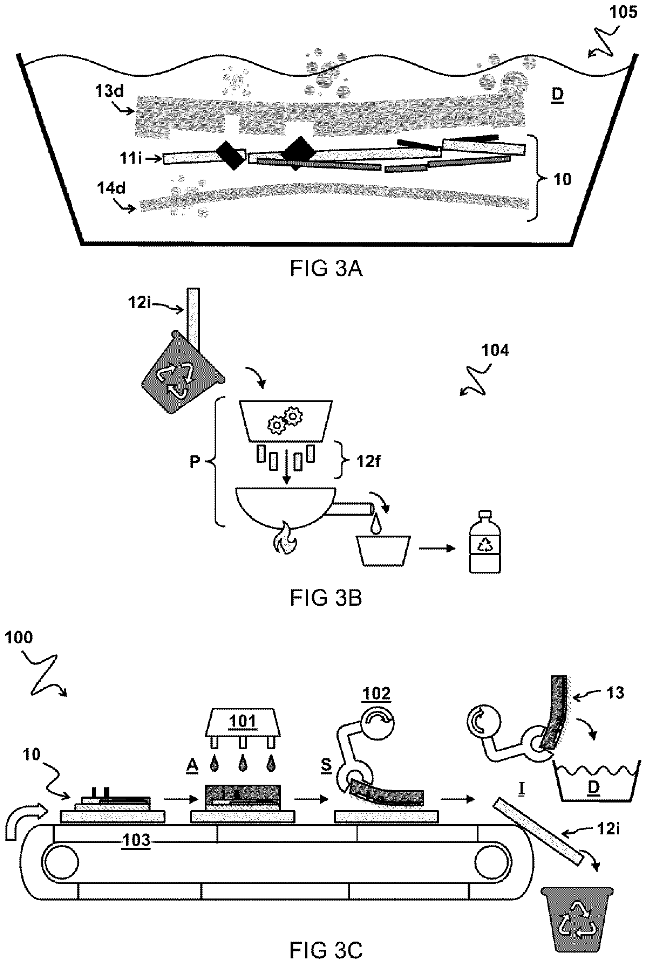

In some embodiments, the carrier substrate 12 is formed by a thermoplastic material. In one embodiment, subsequent to isolating the carrier substrate 12i, the thermoplastic material is recycled by applying a thermomechanical recycling process P, e.g. as shown in FIG 3B. Preferably, the thermoplastic substrate is made of Polyethylene Terephthalate (PET), Polyethylene Furanoate (PEF), PEEK (Polyether Ether Ketone), polymethyl methacrylate (PMMA), polyamide (PA), Thermoplastic Polyurethane (TPU), PC (Polycarbonate), or a combination of one or more of the previously named thermoplastics. Alternatively, or in addition, the thermoplastic substrate is made of bio-degradable or bio-friendly alternatives. Preferably, the (thermoplastic) carrier substrate 12 is recycled by applying a thermomechanical recycling process. Alternatively, or in addition, the thermoplastic substrate can be dissolved.

In other or further embodiments, the set of constituents 11 comprises electric circuit parts 11d, 11c, e.g. a set of conductive tracks, wire bonds, and/or surface mounted device(s). In one embodiment, the electric circuit parts form a printed electronic circuit, e.g. printed metal structure. For example, the carrier substrate 12 is manufactured from a flexible substrate with printed electronics. In one embodiment, the carrier substrate has a thickness of at least one fifty micrometers, five hundred micrometers, up to one thousand micrometers, preferably in a range from one hundred up to three hundred micrometers. Also rigid carrier substrates may be used. In another or further embodiment, the set of constituents comprises a protective coating 11p covering at least one electric circuit part. In some embodiments, a "glob top" is applied as the protective coating 11p over some of the electric circuit parts 11d, 11c to provide environmental protection, mechanical support, and insulation. For example, liquid epoxy resin is dispensed or applied onto the target area, covering the electronic part. Once applied, the material cures and hardens, forming a protective layer against moisture, chemicals, mechanical damage, and other environmental factors. Alternatively, or in addition, the set of constituents may comprise a graphics and/or cosmetics layer, e.g. a layer of ink underneath and/or on top of some of the electronic circuit parts. The graphics layer is typically very thin and fragile and can therefore easily break and contaminate the carrier substrate to be recycled. By applying the counter-substrate 13 to hold together at least part of a graphics layer, the carrier substrate 12 can be isolated with less or no contamination from graphics layer debris as compared to a recycling process without the counter-substrate.

In yet further embodiments, the counter-substrate 13 is separated from the carrier substrate 12 by peeling the counter-substrate 13 from/off the carrier substrate 12. In one embodiment, the peeling is performed by fixing the carrier substrate 12 and applying a force on the counter-substrate 13 in a direction opposite to the carrier substrate 12, e.g. as indicated in FIG 1C by the arrow "S". Alternatively, or in addition, the force is applied to the carrier substrate 12 while the counter-substrate 13 is held stationary. In some embodiments, either of the substrates 12,13 may be held and/or contacted by a mechanical apparatus, e.g. a clamp, a suction device, e.g. a suction cup, and/or using a magnetic device, e.g. an electromagnet. In one embodiment (not shown), the counter-substrate 13 and/or the set of constituents 11 is separated from the carrier substrate 12 using a tool, such as a rotary tool, having a sticky surface. For example, the sticky surface is configured to stick to the counter-substrate 13 and/or the set of constituents 11. Preferably, the sticky surface is reusable and/or cleanable, e.g. formed by a flexible and/or conformable surface. Alternatively, or additionally, the sticky surface comprises a gel-based and/or silicone-based adhesive.

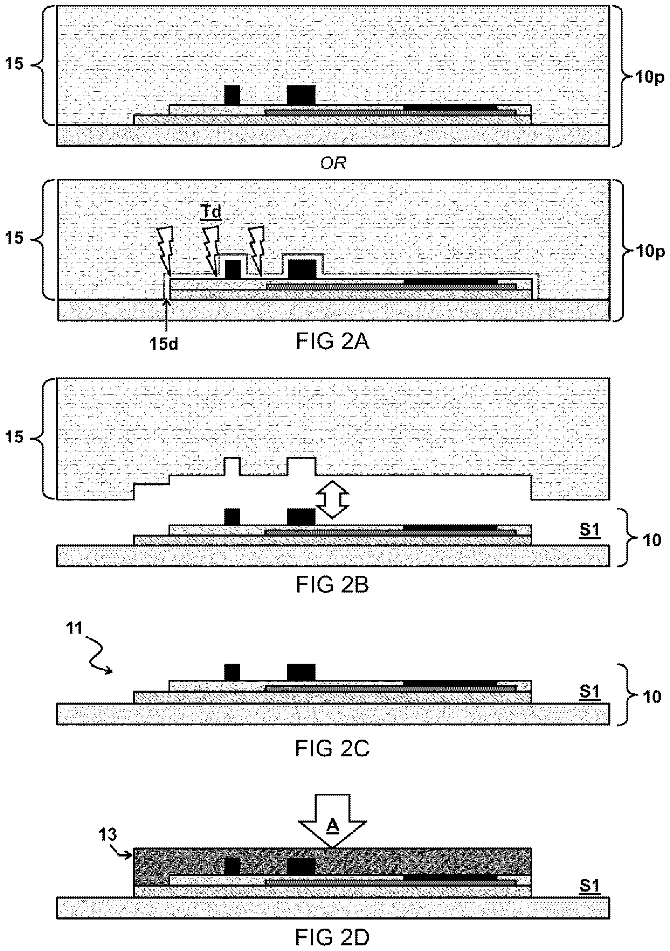

FIGs 2A-D illustrate the recycling of an encapsulated stack 10 and/or stack precursor 10p. In some embodiments, the method of recycling comprises, prior to applying the counter-substrate 13, removing an existing layer 15 covering the set of constituents 11 on a stack precursor 10p, e.g. removing an injection molded layer, a laminated encapsulation layer, or a casted encapsulation layer. In one embodiment, the existing layer 15 has a thickness of five hundred micrometers, three thousand micrometers, up to five thousand micrometers, preferably in a range from one thousand up to three thousand micrometers. In another or further embodiment, removing the existing layer 15 from a stack precursor 10p comprises applying a delamination trigger Td to a delamination layer 15d. In another or further embodiment, removing the existing layer 15 from a stack precursor 10p comprises applying a mechanical delamination step. In another or further embodiment, removing the existing layer 15, e.g. a TPU layer, from a stack precursor 10p comprises applying a dissolution step, e.g. using a certain environment-friendly solvent that is not affecting other components of the stack 10.

FIG 3A illustrates the recycling of a counter-substrate 13. In some embodiments, subsequent to separating the counter-substrate 13 from the carrier substrate 12, the counter-substrate 13 is dissolved D for retrieving the set of constituents 11 from the counter-substrate 13. For example, the dissolving is effected by a dissolving station 105 configured to dissolve D the counter-substrate 13 for retrieving the set of constituents 11. In one embodiment, the set of constituents 11 is separated from the dissolved and/or disintegrated counter-substrate 13d by means of a filtration, e.g. using a sieve, and/or a selective adhesion, e.g. using a magnet. Alternatively, or in addition, the set of constituents 11 is mechanically separated from each other and/or from the counter-substrate 13.

In other or further embodiments, the counter-substrate 13 is configured to be separable from the set of constituents 11 by being formed of a biodegradable and/or water-soluble material. In one embodiment, the biodegradability comprises exposing the counter-substrate 13 to microorganisms such as bacteria or enzymes to break down molecules of the biodegradable counter-substrate 13 into simpler, environmentally benign substances. In another or further embodiment, the water solubility comprises dissolving D the counter-substrate 13 in water to form a clear and/or homogeneous solution. Preferably, the counter-substrate 13 comprises bio-based polymers, e.g. poly(L-lactic acid), poly(ε-caprolactone), poly(3-hydroxybutarate), vegetable oil-based polyesters, epoxy and polyurethanes, in addition to naturally occurring polymers and Polyvinyl Alcohol (PVOH). Alternatively, or in addition, in applications requiring improved adhesive strength of the counter-substrate 13 as compared to that of a weak adhering material, e.g. PVOH, the counter-substrate 13 comprises an additional thermoplastic polyurethane polymer containing e.g. caprolactone as part of its composition and is formulated in a water-based dispersion or emulsion. In one embodiment, recycling of the bio-based counter-substrate 13 comprises dissolving D of the counter-substrate 13 in a solvent, e.g. water. In other or further embodiment, the counter-substrate 13 is separable from the set of constituents 11 using a cleanable and/or reusable gel-based and/or silicone-based adhesive. For example, the counter-substrate 13 may be peeled off using a rotary tool configured to stick to the counter-substrate 13.

FIG 3B illustrates the recycling of an isolated carrier substrate 12i. In some embodiments, the carrier substrate 12i is shredded into flakes 12f. In one embodiment, the flakes 12f are melted and provided for further processing to produce a recycled product, e.g. a plastic bottle. Alternatively, or in addition, the flakes 12f are ground into a powder, e.g. plastic substrate powder. For example, the recycling is effected by a thermomechanical processing station 104 configured to recycle the isolated carrier substrate 12i.

FIG 3C illustrates a system 100 for recycling a stack 10 comprising a set of constituents 11 disposed on a first side S 1 of a carrier substrate 12. In some embodiments, the system is configured to apply A, e.g. by an applicator 101, a counter-substrate 13 to the first side S1 of the carrier substrate 12 to encapsulate and/or adhere to the set of constituents 11. Preferably, the applicator 101 is configured to apply the counter-substrate 13 in an at least partially liquified form. For example, the applicator 101 comprises a spray coating device. Also other ways of applying the counter-substrate 13 in liquid or solid form can be envisaged, e.g. using a reversible and/or removable adhesive. In other or further embodiments, the system 100 is configured to isolate (I), e.g. by a separator 102, the carrier substrate 12 from the set of constituents 11 by separating S the counter-substrate 13 from the carrier substrate 12. In one embodiment, the separator 102 comprises a mechanical apparatus, e.g. a clamp, a suction device, e.g. a suction cup, and/or a magnetic device, e.g. an electromagnet. Preferably, the counter-substrate 13 is configured to hold the set of constituents 11 together while being isolated from the carrier substrate 12. In some embodiments, the system 100 comprises a thermomechanical processing station 104, e.g. as illustrated in FIG 3B. In other or further embodiments, the system 100 comprises a metallurgic station for retrieving metals from the set of constituents 11i. In yet other or further embodiments, the system 100 comprises a dissolving station 105, e.g. as illustrated in FIG 3A.

In some embodiments (not shown here), the system 100 is configured to remove an existing layer 15 covering the set of constituents 11 on a stack precursor 10p prior to applying the counter-substrate 13. In yet further embodiments, the system 100 is configured to separate the isolated carrier substrate 12i from the counter-substrate 13 for further recycling. In one embodiment, the isolated carrier substrate 12i is recycled by a thermomechanical recycling process P. In another or further embodiment, the counter-substrate 13 is dissolved D and/or at least partially disintegrated for retrieving the set of constituents 11 from the counter-substrate 13. In yet further embodiments, the system 100 is used to recycle in-mold structural electronics, flexible lighting foils, flexible sensors, microelectromechanical systems, chips, near field communication modules, etc.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise.

## Claims

1. A method of recycling a stack (10) comprising a set of constituents (11) disposed on a first side (S1) of a carrier substrate (12), the method comprising
applying (A) a counter-substrate (13) onto the first side (S1) of the carrier substrate (12) to encapsulate and/or adhere to the set of constituents (11); and
isolating (I) the carrier substrate (12) from the set of constituents (11) by separating (S) the counter-substrate (13) from the carrier substrate (12), wherein the counter-substrate (13) is configured to hold together the set of constituents (11) while being isolated from the carrier substrate (12).

2. The method according to the preceding claim, wherein the counter-substrate (13) is applied onto the set of constituents (11) as an at least partially liquefied material (13m), wherein the material is solidified after application to form the counter-substrate (13).

3. The method according to any of the preceding claims, wherein the stack (10) comprises a sacrificial layer (14) between the carrier substrate (12) and the set of constituents (11) for facilitating the separating of the set of constituents (11) from the carrier substrate (12).

4. The method according to the preceding claim, wherein the method comprises applying a trigger (T) to the sacrificial layer (14) after applying the counter-substrate (13), wherein the trigger (T) is configured to weaken, degrade, disintegrate, and/or release adhesion of the sacrificial layer (14) to the carrier substrate (12).

5. The method according to any of the preceding claims, wherein the carrier substrate (12) is formed by a thermoplastic material; wherein subsequent to isolating the carrier substrate (12i), the thermoplastic material is recycled using a thermomechanical recycling process (P).

6. The method according to any of the preceding claims, wherein the set of constituents (11) comprises electric circuit parts (11d, 11c).

7. The method according to the preceding claim, wherein the set of constituents comprises a protective coating (11p) covering at least one electric circuit part (11d, 11c).

8. The method according to any of the preceding claims, wherein the counter-substrate (13) is separated from the carrier substrate (12) by peeling the counter-substrate (13), holding together the set of constituents (11), from the carrier substrate (12).

9. The method according to any of the preceding claims, wherein, prior to applying the counter-substrate (13), an existing layer (15) covering the set of constituents (11) is removed.

10. The method according to any of the preceding claims, wherein, subsequent to separating the counter-substrate (13) from the carrier substrate (12), the counter-substrate (13) is dissolved (D) and/or at least partially disintegrated for retrieving the set of constituents (11) from the counter-substrate (13).

11. The method according to any of the preceding claims, wherein the counter-substrate (13) is formed of a biodegradable and/or water-soluble material.

12. The method according to the preceding claim, wherein the counter-substrate (13) comprises polyvinyl alcohol, preferably including a fraction of water-based caprolactone thermoplastic polyurethane for improving adhesive strength.

13. A system (100) for recycling a stack (10) comprising a set of constituents (11) disposed on a first side (S1) of a carrier substrate (12), wherein the system (100) comprises
an applicator (101) configured to apply (A) a counter-substrate (13) onto the first side (S1) of the carrier substrate (12) to encapsulate and/or adhere to the set of constituents (11); and
a separator (102) configured to isolate (I) the carrier substrate (12) from the set of constituents (11) by separating (S) the counter-substrate (13) from the carrier substrate (12), wherein the counter-substrate (13) is configured to hold together the set of constituents (11) while being isolated from the carrier substrate (12).

14. The system (100) according to the preceding claim, wherein the system (100) is configured to remove an existing layer (15) covering the set of constituents (11) on the stack precursor (10p) prior to applying the counter-substrate (13).

15. The system (100) according to any of the two preceding claims, further comprising
a thermomechanical processing station (104) configured to recycle the isolated carrier substrate (12i); and/or
a dissolving station (105) configured to dissolve (D) the counter-substrate (13) for retrieving the set of constituents (11).
